Europäisches Patentamt

European Patent Office

Office européen des brevets

(11) Publication number: **0 068 019**
**B1**

# EUROPEAN PATENT SPECIFICATION

(45) Date of publication of patent specification: **02.12.87**

(51) Int. Cl.⁴: **G 08 B 13/18, H 03 K 17/00**

(21) Application number: **82900528.9**

(22) Date of filing: **28.12.81**

(86) International application number:
**PCT/US81/01769**

(87) International publication number:
**WO 82/02270 08.07.82 Gazette 82/17**

(54) **CONTROL DEVICE RESPONSIVE TO INFRARED RADIATION.**

(30) Priority: **29.12.80 US 220963**

(43) Date of publication of application:
**05.01.83 Bulletin 83/01**

(45) Publication of the grant of the patent:
**02.12.87 Bulletin 87/49**

(84) Designated Contracting States:
**AT BE CH DE FR GB LI LU NL SE**

(56) References cited:
**DE-B-2 606 453**
**DE-B-2 836 734**
**GB-A-1 246 296**
**GB-A-2 034 115**
**US-A-3 760 399**
**US-A-3 955 184**
**US-A-3 988 726**
**US-A-4 016 428**
**US-A-4 021 679**
**US-A-4 179 691**
**US-A-4 238 675**

(73) Proprietor: **ROTHENHAUS, Robert**
**37-25 223rd Street**
**Bayside, NY 11361 (US)**
(73) Proprietor: **BLISSET, Kitson**
**515 Nassau Avenue**
**Freeport, NY 11520 (US)**
(73) Proprietor: **DUNBAR, Robert A.**
**2 Bay View Drive**
**Swampscott, MA 01907 (US)**

(72) Inventor: **DUNBAR, Robert A.**
**2 Bay View Drive**
**Swampscott, MA 01907 (US)**

(74) Representative: **Wright, Peter David John et al**
**R.G.C. Jenkins & Co. 26 Caxton Street**
**London SW1H 0RJ (GB)**

Courier Press, Leamington Spa, England.

EP 0 068 019 B1

## Description

The present invention relates to an improved device able to control such items as interior lighting in response to the presence or absence of a person within the service area of the item.

U.S. Patent 4,107,941 discloses a motion detector which is used to detect the presence of a person in a room and to provide a signal when motion is detected. A control circuit produces no output signal whilst motion is being detected, but as soon as the motion detector starts producing an output a signal is produced so as to turn off lights after a period of, e.g., 20 minutes determined by a delay circuit.

The circuit may employ an infra-red detector, and other devices responsive to infrared energy radiating from a body are known for detecting the intrusion of the body into the area monitored by the device. Examples of such devices are disclosed in U.S. Patents 3,896,311, 3,928,843, 4,179,691 and 4,238,675. U.S. 4,238,675, for example, discloses a device responsive to heat emanating from a human body for controlling an auxiliary current line, the device comprising detection means including an infrared detector for producing detection signals in response to infrared radiation in the frequency spectrum emitted by the human body, circuit means, said circuit means including timing means and being adapted to receive said detection signals for amplifying them and producing a control signal in response to those detection signals resulting from movement of the human body emitting infrared radiation in said spectrum, and control means adapted to receive said control signal for controlling said current line in response thereto. However, such devices are not suitable for providing a simple, inexpensive and compact system for controlling a current line to items such as interior lighting or room air conditioners in order to deactivate these items when no-one is within their service area.

According to the present invention there is provided a device responsive to heat emanating from a human body for controlling an auxiliary current line, comprising

detection means including an infrared detector for producing detection signals in response to infrared radiation in the frequency spectrum emitted by the human body;

circuit means, said circuit means including timing means and being adapted to receive said detection signals for amplifying them and producing a control signal in response to those detection signals resulting from movement of the human body emitting infrared radiation in said spectrum, and

control means adapted to receive said control signal for controlling said current line in response thereto;

characterised in that said timing means is operable to end said control signal when said circuit means fails to receive a detection signal for a time period preselected to be longer than the time period expected between movements of a human body within the field of view of said detector, and in that said detection means includes a single infrared detector for receiving infrared radiation from a human body without reflection by a collecting mirror.

The preferred embodiment of the invention provides a control device, suitable for example for controlling lighting or air conditioning, which is both relatively inexpensive and of a minimal number of components, and yet is highly reliable.

In preferred form, the control means closes the auxiliary current line upon receipt of a control signal of a predetermined voltage level and thereafter opens the current line upon the ending of the control signal.

The timing circuit preferably includes a capacitor initially charged by the control signal and connected to a threshold detector continuing the control signal as long as the capacitor maintains a prescribed charge level. A resistor is connected to the capacitor to enable the capacitor to maintain its prescribed charge level for the necessary time period.

The infrared detector is preferably a pyroelectric detector including an optical filter coated to pass only a narrow band containing the frequency spectrum and may be fitted within a housing having a window spaced from the side of the detector receiving radiation. Such window is preferably made from polyethylene and serves to prevent convective heat transfer to the detector.

The control device of the present invention preferably includes several circuit elements to provide reliable sensitivity and these include a filter circuit for attenuating signals produced below a certain frequency to retain those higher frequency signals corresponding to movement of a human body. Also, a comparator circuit may be included which receives the amplified detection signal and produces the control signal only when the detection signal exceeds a predetermined value.

An arrangement embodying the present invention will now be described by way of example, with reference to the accompanying drawings, in which:

Fig. 1 is a block diagram illustrating electronic components of a preferred embodiment of the present invention;

Fig. 2 is a sectional view of one form of housing for the electronic components of the present invention;

Fig. 3 is a top plan view of portions of the housing of Fig. 2 taken along line 3—3 of Fig. 2;

Fig. 4 is a side plan view of the locator of Fig. 2; and

Fig. 5 is a diagram illustrating the circuitry of a preferred embodiment of the present invention.

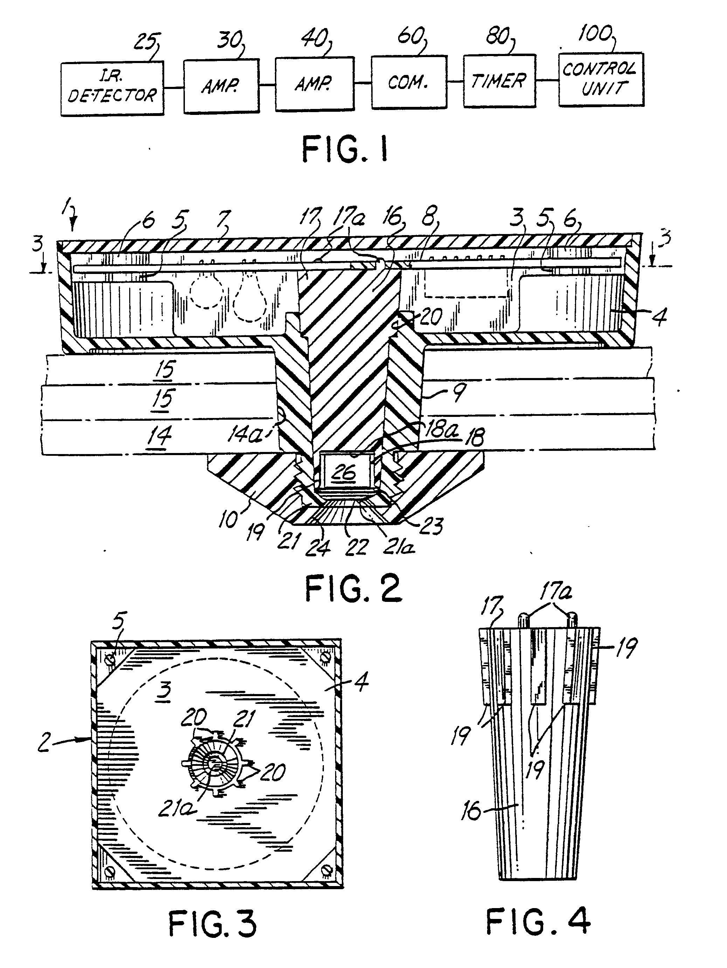

The electronic components of the control device of the illustrated embodiment are shown generally in the block diagram of Fig. 1, and include an infrared detector 25 able to produce detection signals in response to infrared radiation in the frequency spectrum emitted from the

2

human body. The detector 25 includes a preamplifier to provide an output signal of relatively high value, and a pyroelectric detector such as the model 5L21 pyroelectric detector of Plessey Optoelectronics and Microwave, Ltd. of Northamptonshire, England is preferred.

The signal produced by the detector 25 is sent to a first amplifier stage 30, and then to a second amplifier stage 40 which has a low pass filter for those signals changing at a frequency below a predetermined value. The infrared detector will respond with relatively low frequency signals to changes in temperature of a stationary object within its field of view, and will respond with higher frequency signals to movements within the field of view of an object having a relatively constant temperature level. Consequently, the low pass filter will serve as an electronic filter eliminating signals produced by mere temperature change of a stationary object, such as those produced by incident radiation from a carpet being warmed or cooled from sunlight or an incandescent light bulb, and retain the higher frequency signals corresponding to movement of a body emanating radiation in the desired spectrum.

The signals emerging from the amplifier stage 40 are sent to a comparator 60 which produces a control signal when the signal from amplifier stage 40 exceeds a predetermined level. The control signal from the comparator 60 is passed by a timer 80 to a control unit which preferably closes a current line in response to the presence of the control signal. The timer 80 serves to end the signal from the comparator 60, and thus open the current line, when the detector fails to produce another detection signal for a time period longer than that expected between movements of a person within the field of view of the detector.

The control device of the illustrated embodiment of the present invention may be housed in any of several ways and, as illustrated, is fitted within housing 1 formed of a synthetic material such as ABS copolymer plated with a metallic finish by known vacuum techniques. The housing includes a generally rectangular base portion 2 having a central recess area 3 surrounded by a peripheral seat portion 4. The peripheral seal portion carries a plurality of spacers 5 lying oppositely to spacers 6 carried by the back plate 7 of the housing. A printed circuit board 8 is held between aligned spacers 5 and 6 and carries the majority of the electronic components of the device. Depending from the central recess area 3 is a depending neck portion 9 adapted to receive a retaining element 10 on its lower portion.

The infrared detector 25 includes a hermetically sealed container 26 fitted within the lower portion of the neck portion 9 and having a small opening covered by a filter of infrared-transparent germanium coated to pass only a narrow band of infrared radiation containing the frequency spectrum emitted by the human body.

This band preferably includes radiation having only wavelengths between 8 µm and 14 µm so the filter thus serves as an optical filter narrowing the spectral sensitivity of the detector.

The control device may be installed easily even in existing building structures and the like by placing the base portion 2 behind an opening 14a in a ceiling or wall unit 14 or the like with suitable resilient spacing elements 15 placed between the base portion and ceiling unit. The neck portion 9 may then be inserted through the opening 14a until its lower portion protrudes into the service area of an item to be controlled by the control device. The retaining element 10 will then be tightened down on the protruding lower portion to secure the control device in place. The retaining element 10 preferably is threaded onto the lower portion of the neck portion, but may be secured in other ways, such as by being press-fitted or snapped into place through resilient locking tabs.

The neck portion 9 is generally circular in cross-section and receives a locator 16 fitting axially therein and having a rear surface 17 secured to the printed circuit board 8 by deformable posts 17a fixed within mating apertures in the board. In its end portion, the locator 16 has a recess 18 surrounded by a rim portion 19. The back wall 18a of the recess receives and holds the container 26 for the infrared detector. The upper portion of the locator 16 has a plurality of longitudinally extending ribs 19 spaced circumferentially therearound. These ribs are complementary with longitudinal recesses 20 formed in the inner wall of the neck portion 9. In this way, the locator will be easily placed and held within the neck portion to position the detector accurately within the control device.

The end portion of the neck portion 9 includes a bottom wall 21 having a central opening 21a therethrough. An outer window 22 lies over this central opening and is held in spaced relation from the detector 25 by an O-ring 23 compressed between the rim portion 19 of the locator and the outer window 22. The outer window prevents air currents from reaching the surface of the detector container 26 to thereby reduce false triggering of the detector by convective heat transfer. The outer window 22 must, of course, be transparent to infrared radiation and preferably is an inexpensive sheet of polyethylene.

The field of view of the detector 25 is defined by the geometry of the opening 21a in the bottom wall of the neck portion and the opening 24 formed in the retaining element 10. The openings 21a and 24 are each preferably in the form of a conical frustum flaring outwardly to provide a conical field of view having an angle of between 90° and 120° at its apex.

As an optional feature, the control device may be provided with a cover member fitting over the entire housing and adapted to be mounted to a wall or ceiling unit. In this way, the device may be mounted directly to the outer surface of the wall or ceiling unit without the need for providing a hole therethrough. Such a cover could be snappingly engaged with the housing and would, of course, have a small opening aligned with the detector.

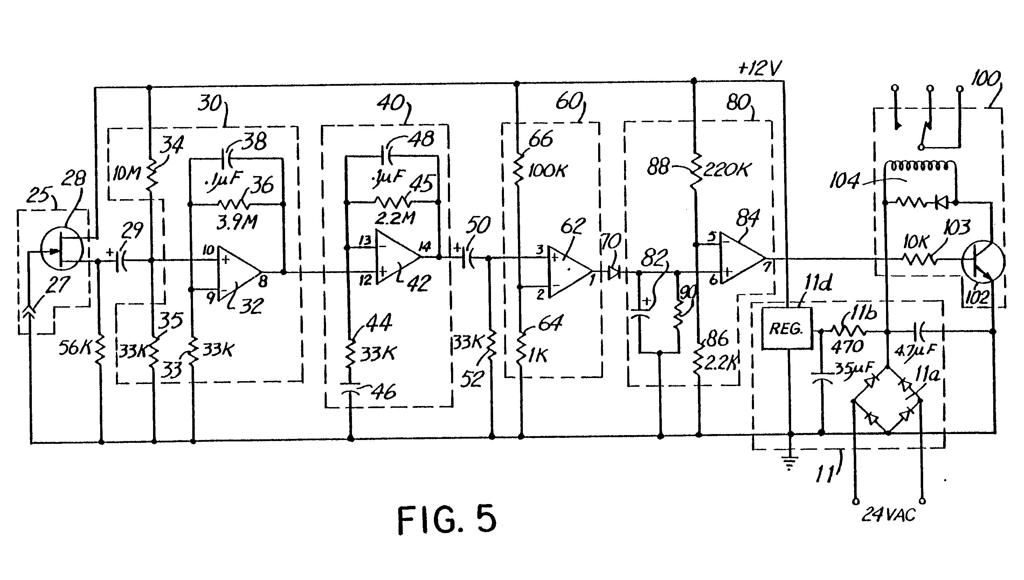

The circuit diagram of Fig. 5 illustrates the circuitry of the illustrated embodiment in more detail. A regulated power source 11 of 12V is formed by the one amp bridge rectifier 11a connected throught the resistor 11b across the capacitor 11c and three terminal 12V voltage regulator 11d. The infrared detector 25 is connected as shown to the power source and includes a pyroelectric element 27 which changes its electrical field characteristics according to changes in the radiant energy impinging on its surface. Whenever a person moves within the field of view of the pyroelectric element 27 there is a net change in the level of radiation reaching the pyroelectric element, and this net change of radiation produces a corresponding signal to the gate of the J-FET preamplifier 28 having its source and drain connected across the regulated voltage supply. The J-FET preamplifier and pyroelectric element are formed as a single circuit component and thus produce a relatively high quality output signal.

The change in voltage level thus produced across the J-FET preamplifier produces a changing signal whose AC components are coupled to the amplifier stage 30 by the capacitor 29. Amplifier stage 30 includes an operational amplifier 32 which may be one of four operational amplifiers provided on a single integrated circuit, such as the LM324N sold by National Semiconductor.

The pin connections for such an integrated circuit containing four operational amplifiers are shown in Fig. 5 where it can be seen; the input pin 9 of operational amplifier 32 receives a bias supplied by the resistor 33. The AC signal from the detector 25 is coupled to the input pin 10 to produce an output at pin 8 corresponding to the net change in the AC signal, which may be an increasing signal produced by motion toward the detector 25, or decreasing signal produced by motion away from the detector. Resistors 36 and 33 are selected to set an overall gain of about 100 for the amplifier stage 30, and capacitor 38 is selected to reduce the adverse effects of higher frequency noise, such as those which may be produced from 60 Hz transmission lines or the like.

Further amplification takes place in the second amplifier stage 40 comprised of operational amplifier 42 preferably formed by another of the operational amplifiers of the single integrated circuit. Resistors 44 and 45 are selected to provide an AC gain of about 60. Further, amplifier stage 40 includes a low pass filter formed by resistor 44 and capacitor 46 which serve to attenuate gradual changes in the signal input to pin 12. In this way, the DC gain of the second amplifier stage can be set at 1 to produce a low output signal for inputs changing gradually, such as those expected from signals generated by a stationary object. Capacitor 48, similar to capacitor 38 of the first amplifier stage, serves to eliminate environmental noise.

A third operational amplifier 62 forms part of a comparator circuit 60 receiving the output of the second amplifier stage by way of the coupling capacitor 50 and resistor 52. Input pin 2 of operational amplifier 62 receives a bias voltage fixed by the voltage divider formed by resistors 64 and 66. Operational amplifier 62 serves to produce an output at pin 1 for any signal at input pin 3 having a voltage more positive than the fixed bias to pin 2. Consequently, a changing output signal coupled by capacitor 50 and developed by resistor 52 that exceeds a predetermined voltage level of, for example 4.9V, will cause the output of operational amplifier 62 to rise from zero volts to a higher level approaching the regulated voltage supply. In this way, the comparator 60 will serve to produce an output signal for only those amplified signals reaching a preselected value corresponding to motion of a person within the field of view of the detector.

The output from the comparator 60 is passed· through the diode 70 and the timing circuit 80 to the base of an NPN switching transistor 102 by way of resistor 103. The switching transistor, which may be a 2N3471, is rendered conductive by a signal at its base to activate relay 104 adapted to close an auxiliary current line, preferably through a step up transformer.

The high voltage output from the comparator 60 also serves to charge the capacitor 82 relatively instantaneously to a voltage near the regulated line voltage. This voltage also appears at input pin 6 of the fourth operational amplifier 84 which serves to pass a voltage to the base of transistor 102 sufficient to bias the transistor conductive as long as the voltage at input pin 6 is more positive than the voltage produced at pin 5 by the voltage divider formed by resistors 86 and 88.

Resistor 90 is connected to capacitor 82 and serves as a discharge path for the charge placed on the capacitor 82. Consequently, when the signal from the comparator 60 returns to its low voltage state, i.e., when no change in radiation corresponding to movement of a person is noticed by detector 25, capacitor 82 will discharge slowly through resistor 90 at a rate set by the values of capacitor 82 and resistor 90.

The operational amplifier 84 serves as a threshold detector in that when the voltage on capacitor 82 falls below the threshold needed to maintain the output from operational amplifier 84, the output signal at pin 7 of the operational amplifier 84 is ended to render the transistor 102 non-conductive and de-activate relay 104 so as to open the auxiliary current line. The values of capacitor 82 and resistor 90, as well as those of the resistors 86 and 88 fixing the threshold operating voltage of the operational amplifier 84, are selected to assure that the output from operational amplifier 84 will be maintained for a time period longer than that expected between movements of a person within the field of view of the detector 25. A time period of, for example, about eight minutes has been found satisfactory. In this way, the transistor 102 will become conductive to close a current line to interior lighting or the like when a person first enters the field of view of the detector, and will become non-conductive to open the current line eight minutes after the detector fails to sense any human activity.

From the above, it is apparent that the present embodiment includes important features in both its circuitry and structural aspects of its illustrating housing. The control device may be installed readily and includes both optical and electronic filters to provide a high discrimination. Further, the device can be adapted for many uses and, as set forth above, can be made to close a current line to interior lighting or the like whenever someone enters the field of view of the detector, and will keep the current line closed as long as even slight motion, such as simple hand motions or even writing at a desk, are made within the detector's field of view. Thereafter, the control device will open the current line soon after no motion is sensed within the detector's field of view, i.e., after all persons have left the field of view, and will reclose the current line should someone again re-enter the field.

Further, the above functions have been attained with relatively few circuit components and thus the control device can not only be produced inexpensively, but may also be reduced quite simply to one or two integrated circuits easily fitted directly within the item to be controlled. For example, the control device could be fitted within fluorescent light fixtures to control activating current to the ballast with only minimal modification to conventional fixtures.

## Claims

1. A device responsive to heat emanating from a human body for controlling an auxiliary current line, comprising

detection means including an infrared detector (25) for producing detection signals in response to infrared radiation in the frequency spectrum emitted by the human body;

circuit means (30, 40, 60, 80), said circuit means including timing means (80) and being adapted to receive said detection signals for amplifying them and producing a control signal in response to those detection signals resulting from movement of the human body emitting infrared radiation in said spectrum, and

control means (100) adapted to receive said control signal for controlling said current line in response thereto;

characterised in that said timing means (80) is operable to end said control signal when said circuit means (30, 40, 60, 80) fails to receive a detection signal for a time period preselected to be longer than the time period expected between movements of a human body within the field of view of said detector (25), and in that said detection means includes a single infrared detector (25) for receiving infrared radiation from a human body without reflection by a collecting mirror.

2. A device according to claim 1, wherein said control means (100) is arranged to close said current line upon receipt of said control signal.

3. A device according to claim 1 or 2, wherein said timing means (80) includes a capacitor (82) charged by amplified detection signals and connected to a threshold detector (84) for continuing said control signal as long as said capacitor maintains at least a predetermined level of charge and ending said control signal when said capacitor fails to maintain said at least predetermined level of charge, and a resistor (90) connected to said capacitor (82) to enable said capacitor (82) to maintain said at least predetermined level of charge for said time period.

4. A device according to any preceding claim, said detector (25) having an optical filter coated to pass only a narrow band containing said frequency spectrum.

5. A device according to any preceding claim, wherein said detection signals have frequency components indicative of whether the source of infrared radiation is stationary or moving, and said circuit means (30, 40, 60) is operable to distinguish between those detection signals indicative of the movement of a human body from those indicative of a stationary source of infrared radiation.

6. A device according to any preceding claim, said circuit means (30, 40, 60) including a plurality of amplifier stages (30, 40), at least one (40) of said amplifier stages (30, 40) having a filter (44, 46) with a cut-off frequency for eliminating all detection signals changing at a frequency below a predetermined value whereby higher frequency signals corresponding to movement of a body emanating infrared radiation in said spectrum will be retained.

7. A device according to any preceding claim, further including a housing having a depending neck portion (9) having said infrared detector (25) in its lower portion and a retaining element (10) adapted to be secured to the lower portion of said neck portion (9) whereby said device can be installed to a ceiling or wall (14) by inserting said neck portion (9) through an opening (14a) therein and securing said retaining element (10) to the lower portion of said neck portion (9).

8. A device according to claim 7, the bottom portion of said lower portion including an outer window (22) spaced from said detector (25) for preventing convective heat transfer to said detector (25).

9. A device according to claim 8, further including a locator (16) fitting axially within said neck portion (9), said locator having a recess (18) in the end thereof for receiving said infrared detector (25) and structures (19) formed on the upper portion thereof for mating with complementary structures (20) on said neck portion (9).

10. A device according to claim 9, said complementary structures including longitudinally extending ribs (19) protruding from said locator (16) and longitudinal recesses (20) formed in said neck portion (9).

11. A device according to claim 9 or 10, the end portion of said neck portion (9) being generally cylindrical and including a bottom wall (21) having a central opening (21a) therethrough, said outer window (22) lying over said opening (21a), said locator (16) having a peripheral rim portion (19) surrounding said recess (18), and an O-ring (23) lying over said outer window (22) and held in position by said rim portion (19).

12. A device according to any one of claims 8 to 10, the end portion of said neck portion (9) being generally circular in cross section and including a bottom wall (21) having a central opening (21a) therethrough, said opening (21a) being in the form of a conical frustum flaring outwardly at an angle between approximately 90° and 120°.

13. A device according to claim 12, said retaining element (10) having an opening (24) therein formed as a conical frustum and adapted to align with the opening (21a) in said neck portion bottom wall (21).

14. A device according to any one of claims 1 to 6, said detector (25) being fitted within a housing having a window (22) spaced from the side of said detector (25) receiving radiation to prevent convective heat transfer to said detector (25).

## Patentansprüche

1. Gerät, das auf von einem menschlichen Körper ausgehende Wärme zum Steuern einer Hilfsstromleitung anspricht, mit einer einen Infrarotdetektor (25) aufweisenden Detektorvorrichtung zum Erzeugen von Detektionssignalen auf Infrarotstrahlung in dem vom menschlichen Körper ausgesandten Frequenzspektrum hin,

einer Schaltungsvorrichtung (30, 40, 60, 80), die eine Zeitgebervorrichtung (80) aufweist und auf den Empfang der Detektionssignale ausgelegt ist zum Verstärken derselben und zum Erzeugen eines Steuersignals auf die Detektionssignale hin, die sich aus einer Bewegung des menschlichen Körpers ergeben, der Infrarotstrahlung in diesem Spektrum aussendet, und

einer auf den Empfang des Steuersignals ausgelegten Steuervorrichtung (100) zum Steuern der Stromleitung in Abhängigkeit von demselben, dadurch gekennzeichnet, daß die Zeitgebervorrichtung (80) das Steuersignal beendet, wenn die Schaltungsvorrichtung (30, 40, 60, 80) kein Detektionssignal während einer vorbestimmten Periode empfängt, die länger ist als die zwischen Bewegungen des menschlichen Körpers innerhalb des Gesichtsfeldes des Detektors (25) erwartete Zeitdauer, und daß die Detektionsvorrichtung einen einzelnen Infrarotdetektor (25) zum Empfangen von Infrarotstrahlung von einem menschlichen Körper ohne Reflexion durch einen Sammelspiegel empfängt.

2. Gerät nach Anspruch 1, dadurch gekennzeichnet, daß die Steuervorrichtung (100) zum Schließen der Stromleitung auf das Steuersignal hin ausgelegt ist.

3. Gerät nach Anspruch 1 oder 2, dadurch gekennzeichnet, daß die Zeitgebervorrichtung (80) einen durch verstärkte Detektionssignale geladenen und mit einem Schwellendetektor (84) verbundenen Kondensator (82) zum Aufrechterhalten des Steuersignals, solange der Kondensator mindestens eine vorbestimmte Ladungsmenge besitzt, und zum Beenden des Steuersignals, wenn der Kondensator die mindestens vorbestimmte Ladungsmenge nicht mehr besitzt, und einen mit dem Kondensator (82) verbundenen Widerstand (90) aufweist, durch den der Kondensator (82) die mindestens vorbestimmte Ladungsmenge während der Zeitdauer beibehält.

4. Gerät nach einem der vorhergehenden Ansprüche, dadurch gekennzeichnet, daß der Detektor (25) ein derart beschichtetes optisches Filter aufweist, daß nur ein das Frequenzspektrum enthaltendes schmales Band durchgelassen wird.

5. Gerät nach einem der vorhergehenden Ansprüche, dadurch gekennzeichnet, daß die Detektionssignale Frequenzanteile enthalten, die anzeigen, ob die Infrarotstrahlungsquelle ruht oder sich bewegt, und daß die Schaltungsvorrichtung (30, 40, 60) zwischen den die Bewegung eines menschlichen Körpers anzeigenden Detektionssignalen und den eine ruhende Infrarotstrahlungsquelle anzeigenden Detektionssignalen unterscheidet.

6. Gerät nach einem der vorhergehenden Ansprüche, dadurch gekennzeichnet, daß die Schaltungsvorrichtung (30, 40, 60) mehrere Verstärkerstufen (30, 40) aufweist, von denen zumindest eine (40) ein Filter (44, 46) mit einer Grenzfrequenz zum Ausschließen aller Detektionssignale aufweist, die sich bei einer Frequenz unterhalb eines vorbestimmten Wertes ändern, wobei höherfrequente Signale erhalten bleiben, die der Bewegung eines Körpers entsprechen, der Infrarotstrahlung in dem Spektrum aussendet.

7. Gerät nach einem der vorhergehenden Ansprüche, gekennzeichnet, durch ein Gehäuse mit einem Ansatzteil (9), das den Infrarotdetektor (25) in seinem unteren Teil und ein Halteelement (10) aufweist, das am unteren Teil des Ansatzteils (9) befestigbar ist, wodurch das Gerät an einer Decke oder Wand (14) angebracht werden kann, indem das Ansatzteil (9) durch eine Öffnung (14a) in derselben geführt wird und das Halteelement (10) am unteren Teil des Ansatzteils (9) befestigt wird.

8. Gerät nach Anspruch 7, dadurch gekennzeichnet, daß der Bodenbereich des unteren Teils ein äußeres Fenster (22) aufweist, das zum Verhindern eines Konvektionswärmeübergangs auf den Detektor (25) von demselben beabstandet ist.

9. Gerät nach Anspruch 8, gekennzeichnet durch ein Positionierteil (16), das axial in das Ansatzteil (9) eingepaßt ist und eine Aussparung (18) in dessen Endbereich zum Aufnehmen des Infrarotdetektors (25) und von Baugliedern (19) aufweist, die in dessen oberem Teil zum Eingreifen in zusätzliche Bauglieder (20) auf dem Ansatzteil (9) ausgebildet sind.

10. Gerät nach Anspruch 9, dadurch gekennzeichnet, daß die ergänzenden Bauglieder sich länglich erstreckende Rippen (19), die von dem Positionierteil (16) hervorstehen, und in dem Ansatzteil (9) ausgebildete längliche Aussparungen (20) aufweisen.

11. Gerät nach Anspruch 9 oder 10, dadurch gekennzeichnet, daß der Endabschnitt des Ansatzteils (9) im allgemeinen zylindrisch ist und eine Bodenwandung (21) mit einer Zentralöffnung (21a) durch dieselbe aufweist, wobei das äußere Fenster (22) über der Öffnung (21a) liegt, das Positionierteil (16) einen die Aussparung (18) umgebenden äußeren Randbereich (19) aufweist, und ein O-Ring über dem äußeren Fenster (22) liegt und von dem Randbereich (19) in Lage gehalten wird.

12. Gerät nach einem der Ansprüche 8 bis 10, dadurch gekennzeichnet, daß der Endabschnitt des Ansatzteils (9) im allgemeinen im Querschnitt kreisförmig ist und eine Bodenwandung (21) mit einer durch dieselbe hindurchgehenden zentralen Öffnung (21a) aufweist, die die Form eines kegelförmigen Stumpfes hat, der sich nach außen mit einem Winkel zwischen etwa 90° und 120° erweitert.

13. Gerät nach Anspruch 12, dadurch gekennzeichnet, daß das Halteelement (10) eine Öffnung (24) hat, die in demselben in Kegelform ausgebildet ist und zum Ausrichten mit der Öffnung (21a) in der Bodenwandung (21) des Ansatzteils ausgelegt ist.

14. Gerät nach einem der Ansprüche 1 bis 6, dadurch gekennzeichnet, daß der Detektor (25) innerhalb eines Gehäuses mit einem Fenster (22) eingepaßt ist, das von der Strahlungsempfangsseite des Detektors (25) zum Verhindern eines Konvektionswärmeüberganges auf denselben beabstandet ist.

**Revendications**

1. Dispositif sensible à la chaleur qui se dégage d'un corps humain, pour commander un circuit de courant auxiliaire, comprenant:
— des moyens de détection qui renferment un détecteur d'infrarouge (25) générant des signaux de détection en réponse au rayonnement infrarouge présent dans le spectre de fréquences émis par le corps humain;
— des moyens formant circuit (30, 40, 60, 80), lesdits moyens formant circuit renfermant un moyen de temporisation (80) et étant conçus pour recevoir lesdits signaux de détection en vue de les amplifier et de générer un signal de commande en réponse à ceux des signaux de détection, qui résultent d'un mouvement du corps humain émettant le rayonnement infrarouge à l'intérieur dudit spectre, et
— des moyens de commande (100) aptes à recevoir ledit signal de commande pour commander ledit circuit de courant en réponse à ce dernier;

caractérisé en ce que ledit moyen de temporisation (80) peut agir pour mettre fin audit signal de commande quand lesdits moyens formant circuit (30, 40, 60, 80) ne reçoivent plus de signal de détection sur une période de temps présélectionnée pour être plus longue que la période de temps supposée entre des mouvements d'un corps humain à l'intérieur du champ de visée dudit détecteur (25), et en ce que lesdits moyens de détection comprennent un détecteur d'infrarouge unique (25) destiné à capter un rayonnement infrarouge d'un corps humain sans réflexion par un miroir collecteur.

2. Dispositif selon la revendication 1, dans lequel lesdits moyens de commande (100) sont agencés pour fermer ledit circuit de courant à réception dudit signal de commande.

3. Dispositif selon la revendication 1 ou 2, dans lequel ledit moyen de temporisation (80) comprend un condensateur (82) chargé par les signaux de détection amplifiés et connecté à un détecteur de seuil (84) destiné à prolonger ledit signal de commande tant que ledit condensateur maintient au moins un niveau de charge prédéterminé et à mettre fin audit signal de commande quand ledit condensateur ne maintient plus ledit niveau de change prédéterminé au moins, et une résistance (90) connectée audit condensateur (82) pour permettre à ce condensateur (82) de maintenir au moins ledit niveau de charge prédéterminé pendant ladite période temps.

4. Dispositif selon l'une quelconque des revendications précédentes, ledit détecteur (25) comportant un filtre optique pourvu d'un revêtement qui ne laisse passer qu'une bande étroite contenant ledit spectre de fréquences.

5. Dispositif selon l'une quelconque des revendications précédentes, dans lequel lesdits signaux de détection ont des composantes de fréquence qui indiquent si la source de rayonnement infrarouge est fixe ou en mouvement, et lesdits moyens formant circuit (30, 40, 60) interviennent pour distinguer les signaux de détection indiquant le mouvement d'un corps humain de ceux qui indiquent que la source de rayonnement infrarouge est fixe.

6. Dispositif selon l'une quelconque des revendications précédentes, lesdits moyens formant circuit (30, 40, 60) comportant plusieurs étages amplificateurs (30, 40) dont l'un au moins (40) renferme un filtre (44, 46) présentant une fréquence de coupure pour éliminer tous les signaux de détection changeant à une fréquence inférieure à une valeur prédéterminée, ce qui fait que les signaux de fréquence supérieure, correspondant au mouvement d'un corps d'où émane un rayonnement infrarouge situé dans ledit spectre, seront retenus.

7. Dispositif selon l'une quelconque des revendications précédentes, comprenant en outre un boîtier sous lequel pend une partie en forme de col (9) renfermant ledit détecteur d'infrarouge (25) dans sa partie inférieure et un élément de retenue (10) conçu pour être fixé à la partie inférieure de ladite partie en forme de col (9), ledit dispositif pouvant être ainsi monté sur un plafond ou un mur (14) par insertion de ladite partie en forme de col (9) dans une ouverture (14a) ménagée dans ce dernier et fixation dudit élément de retenue (10) à la partie inférieure de ladite partie en forme de col (9).

8. Dispositif selon la revendication 7, la partie de fond de ladite partie inférieure portant une fenêtre extérieure (22) espacée dudit détecteur (25) pour empêcher tout transfert de chaleur par convexion audit détecteur (25).

9. Dispositif selon la revendication 8, comprenant en outre un élément de positionnement (16) s'emboîtant axialement à l'intérieur de ladite partie en forme de col (9), cet élément de positionnement possèdant, à son extrémité, un renfoncement (18) logeant ledit détecteur d'infrarouge (25) et des structures (19) sont formées sur sa partie supérieure pour s'adapter dans des structures complémentaires (20) ménagées sur ladite partie en forme de col (9).

10. Dispositif selon la revendication 9, lesdites structures complémentaires incluant des nervures (19) s'étendant longitudinalement et saillant sur ledit élément de positionnement (16), ainsi que des évidements longitudinaux (20) ménagés dans ladite partie en forme de col (9).

11. Dispositif selon la revendication 9 ou 10, la partie d'extrémité de ladite partie en forme de col (9) présentant une forme générale cylindrique et comprenant une paroi de fond (21) à travers laquelle est ménagée une ouverture centrale (21a), ladite fenêtre extérieure (22) recouvrant ladite ouverture (21a), ledit élément de positionnement (16) présentant une partie constituant un rebord périphérique (19) qui entoure ledit renfoncement (18), et un joint torique (23) s'étendant sur ladite fenêtre extérieure (22) et maintenu en place par ladite partie formant rebord (19).

12. Dispositif selon l'une quelconque des revendications 8 à 10, la partie d'extrémité de la partie en forme de col (9) ayant, en coupe transversale, une forme générale circulaire et comportant une paroi de fond (21) à travers laquelle est formée une ouverture centrale (21a), ladite ouverture (21a) ayant la forme d'un tronc-de-cône s'évasant vers l'extérieur sous un angle ayant une valeur comprise entre environ 90° et 120°.

13. Dispositif selon la revendication 12, ledit élément de retenue (10) présentant une ouverture (24) formée en lui sous la forme d'un tronc-de-cône et apte à venir en alignement avec l'ouverture (21a) présente dans ladite paroi de fond (21) de la partie en forme de col.

14. Dispositif selon l'une quelconque des revendications 1 à 6, ledit détecteur (25) étant logé à l'intérieur d'un boîtier possèdant une fenêtre (22) espacée de la face du détecteur (25), qui capte le rayonnement, afin d'empêcher tout transfert de chaleur par convexion audit détecteur (25).

25  30  40  60  80  100

| I.R. DETECTOR | AMP. | AMP. | COM. | TIMER | CONTROL UNIT |

FIG. 1

FIG. 2

FIG. 3

FIG. 4

FIG. 5